# DEMANDE DE BREVET EUROPEEN

(11) **EP 1 638 146 A2**
(43) Date de publication de la demande: **22.03.2006**
(21) Numéro de dépôt: 05108427.5
(22) Date de dépôt: 14.09.2005
(51) Int. Cl.: H01L 27/02

(54) **Circuit électronique à double alimentation et à moyens de protection contre les claquages, et moyens de protection correspondants**

(30) Priorité: 15.09.2004 FR 0409843
(71) Demandeur: ATMEL NANTES SA, 44306 Nantes Cédex 3 (FR)
(72) Inventeur: Gibet, Stanislas, 44470, CARQUEFOU (FR); Bendraoui, Abdellatif, 44450, SAINT-JULIEN DE CONCELLES (FR); Tual, Mikaël, 44600, SAINT-NAZAIRE (FR)
(74) Mandataire: Bioret, Ludovic

(57) **Abrégé**

L'invention concerne un circuit électronique (30) comprenant une double alimentation, une première alimentation (35) pour une première portion (301) dudit circuit et une seconde alimentation pour une seconde portion (32) dudit circuit,
et des moyens de protection d'au moins un transistor de ladite première portion, comprenant un premier transistor de protection (311) dont le drain est relié à une connexion entre ladite première portion (301) et ladite seconde portion (32) et la grille à ladite première alimentation (35),

Selon l'invention, un tel circuit comprend des premiers moyens de réduction (38) de la tension entre le drain et la grille dudit premier transistor de protection (311).

## Description

### 1. Domaine de l'invention

Le domaine de l'invention est celui des circuits électroniques intégrés et plus particulièrement celui des circuits intégrés à double alimentation.

Plus précisément, l'invention concerne la protection de ces circuits intégrés, notamment contre les claquages des transistors et les décharges électrostatiques.

### 2. Solutions de l'art antérieur

Les circuits intégrés fonctionnaient historiquement avec une alimentation standard d'environ 5V. Cependant la nécessité croissante de réduire la consommation et les dimensions des systèmes électroniques à base de circuits intégrés a conduit les concepteurs de tels circuits à réduire les tensions d'alimentation.

Cependant, l'uniformisation des tensions d'alimentation prend du temps et la réduction de la tension d'alimentation ne connaît pas la même priorité dans toutes les applications de l'industrie électronique. Ainsi, des composants fonctionnant en 5V, selon les anciens standards, sont fréquemment interconnectés à des composants fonctionnant avec des alimentations plus faibles, selon des nouveaux standards, afin de réaliser des systèmes électroniques.

Afm de pouvoir réaliser ces systèmes électroniques à alimentation « mixte », ou à double alimentation, les concepteurs de circuits intégrés doivent s'assurer que les composants fonctionnant selon les nouvelles tensions d'alimentation plus basses, ne soient pas anormalement dégradés lorsqu'ils doivent communiquer avec des systèmes fonctionnant en 5V.

Les circuits doivent ainsi être protégés contre les risques de :
- claquage des jonctions ;
- rupture de l'oxyde de grille ;
- courants de fuite indésirables.

Un problème majeur des circuits électroniques intégrés est leur sensibilité aux décharges électrostatiques. Une décharge électrique est une impulsion électrique de très haute tension et de très courte durée qui est généralement due à l'électricité statique.

En effet, lorsqu'une telle décharge électrostatique est appliquée à un transistor, sa couche d'oxyde peut être détruite, ou endommagée. C'est pourquoi les contacts d'entrée/sortie (ou pads d'entrée/sortie) d'un circuit intégré doivent être protégés de sorte que les décharges électriques n'atteignent pas ses couches d'oxyde.

Plusieurs techniques ont été proposées pour protéger un circuit intégré des effets d'une décharge électrostatique.

Une première technique est basée sur la mise en oeuvre de deux diodes, l'une connectée entre le contact d'entrée/sortie du circuit et la masse du circuit et l'autre entre une alimentation du circuit et le contact d'entrée/sortie. Ainsi, en fonction du signe de la décharge électrostatique, la diode qui est passante court-circuite le courant de la décharge soit vers la masse soit vers le plan d'alimentation.

Cependant, en fonctionnement normal et lorsqu'une tension plus forte que la tension d'alimentation est appliquée sur le contact d'entrée/sortie, elle se trouve court-circuitée vers l'alimentation par une des diodes. Ainsi, on ne peut pas appliquer de tension supérieure à l'alimentation sur le contact d'entrée/sortie, ce qui empêche de placer un tel circuit alimenté par exemple en 3V dans un système électronique fonctionnant en 5V selon les anciens standards d'alimentation.

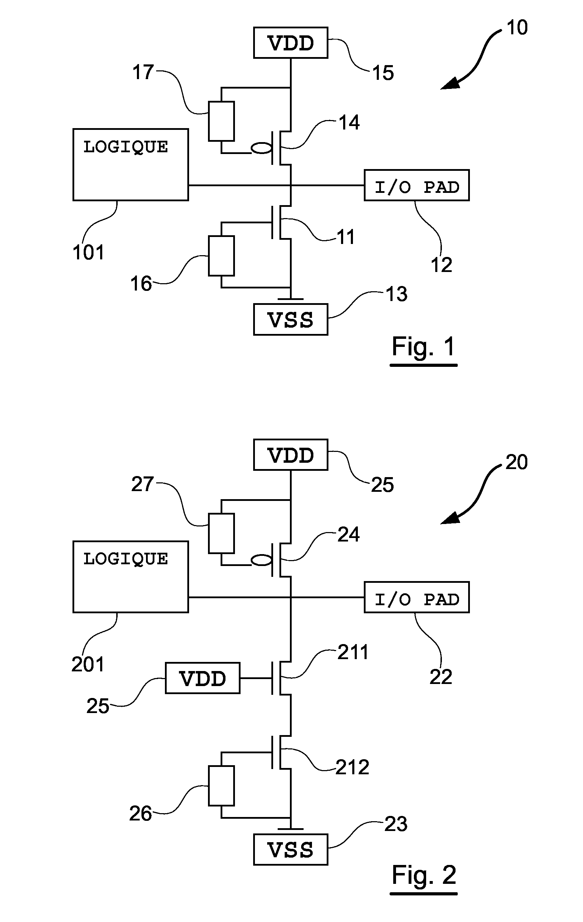

Une deuxième technique connue de protection d'un circuit intégré 10 comprenant un module logique 101 est illustrée par la figure 1. Elle met en oeuvre un transistor NMOS 11, dont le drain est connecté à un contact d'entrée/sortie 12 du circuit 10, la source est connectée à la masse 13 du circuit 10 et la grille est reliée via une première résistance 16 à la masse 13. Ce transistor NMOS 11 court-circuite vers la masse le courant électrostatique des décharges négatives.

Pour les décharges positives, cette technique met en oeuvre un transistor PMOS 14, dont la source est connectée au contact d'entrée/sortie 12, le drain est connecté à l'alimentation 15 et la grille est reliée, via une seconde résistance 17, à l'alimentation 15. Ce dernier joue un rôle symétrique à celui du transistor NMOS 11 en court-circuitant vers l'alimentation 15 le courant électrostatique des décharges positives.

Dans le cas d'une alimentation 15 de 3V, l'application d'une tension de 5V sur le contact d'entrée/sortie 12 génère une tension drain-grille supérieure à ce que peut supporter l'oxyde de grille du transistor NMOS 11. Ainsi, on peut observer une dégradation anormale du canal et de la couche d'oxyde et un risque de claquage de ce transistor NMOS 11 si l'on utilise un tel circuit 10 alimenté en 3V dans un système électronique fonctionnant en 5V.

Une troisième technique de protection d'un circuit intégré 20 comprenant un module de logique 201 est présentée dans le document US-5 932 918, et illustrée par la figure 2. Elle met en oeuvre deux transistors NMOS 211 et 212 empilés pour la protection contre les décharges électrostatiques négatives. Pour les décharges électrostatiques positives, un montage à base d'un transistor PMOS 24 et d'une résistance 27, identique à celui de la figure 1, est mis en oeuvre.

Le drain du premier transistor 211 est connecté au contact d'entrée/sortie 22 ainsi qu'au transistor PMOS 24, sa grille est connectée à l'alimentation 25 et sa source est reliée au drain du second transistor 212. La grille du second transistor 212 est reliée via une résistance 26 à la masse 23 du circuit 20 et sa source, elle aussi, est reliée à la masse 23.

De la même manière que pour la seconde technique, dans le cas par exemple d'une alimentation 25 de 3V, l'application d'une tension de 5V sur le contact d'entrée/sortie 22 génère une tension drain-grille supérieure à ce que peut supporter l'oxyde de grille du premier transistor 211. Ainsi, cette troisième technique pose aussi des problèmes de dégradation anormale et de risque de claquage du transistor 211 si l'on utilise un tel circuit 20 alimenté en 3V dans un système fonctionnant en 5V selon les anciens standards.

### 3. Objectifs de l'invention

L'invention a notamment pour objectif de pallier ces inconvénients de l'art antérieur.

Plus précisément, un objectif de l'invention est de fournir une telle technique qui permette de protéger les circuits des claquages et des dégradations anormales de leurs composants lorsqu'ils reçoivent une tension supérieure à leur tension d'alimentation.

Un autre objectif de l'invention est de fournir une nouvelle technique de protection des circuits intégrés à double alimentation, notamment contre les décharges électrostatiques.

L'invention a aussi pour objectif de fournir une telle technique qui n'occupe qu'une faible surface de silicium et qui ne nécessite pas d'étape supplémentaire dans le process de fabrication du circuit.

L'invention a encore pour objectif de fournir une telle technique qui soit simple à mettre en oeuvre et peu coûteuse.

### 4. Caractéristiques essentielles de l'invention

Ces objectifs, ainsi que d'autres qui apparaîtront par la suite, sont atteints à l'aide d'un circuit électronique comprenant une double alimentation, une première alimentation pour une première portion dudit circuit et une seconde alimentation pour une seconde portion dudit circuit, et des moyens de protection d'au moins un transistor de ladite première portion, comprenant un premier transistor de protection dont le drain est relié à une connexion entre ladite première portion et ladite seconde portion et la grille à ladite première alimentation,

Selon l'invention, un tel circuit comprend des premiers moyens de réduction de la tension entre le drain et la grille dudit premier transistor de protection.

Ainsi la réduction de la tension entre le drain et la grille du premier transistor permet de le protéger contre d'éventuelles dégradations anormales ou même contre le claquage résultant de l'application de tensions élevées à ce transistor. Cette technique permet donc également de protéger le circuit des décharges électrostatiques.

Avantageusement, ledit premier transistor de protection est monté en diode.

Préférentiellement, lesdits premiers moyens de réduction de la tension comprennent une première résistance montée entre la grille et la source dudit premier transistor.

Ainsi ces moyens de réduction de la tension occupent une faible surface de silicium et ne nécessitent pas d'étapes supplémentaires dans le process de fabrication du circuit.

D'autre part ces moyens de réduction de la tension sont simple et peu coûteux.

Selon une caractéristique avantageuse de l'invention, ladite première résistance est montée entre ladite première alimentation et la grille dudit premier transistor de protection, la source de ce dernier étant directement reliée à ladite première alimentation.

Préférentiellement, lesdits moyens de protection comprennent un deuxième transistor, dont le drain est relié à la source dudit premier transistor et la source est reliée à la masse.

Selon un mode de réalisation préférentiel de l'invention, lesdits moyens de protection comprennent une deuxième résistance, interconnectant la grille et la source dudit deuxième transistor.

Préférentiellement, lesdits premier et deuxième transistors sont identiques.

Avantageusement, lesdits moyens de protection comprennent un troisième transistor dont la source est reliée à ladite connexion entre ladite première portion et ladite seconde portion et le drain à ladite première alimentation.

Selon une caractéristique avantageuse de l'invention, lesdits moyens de protection comprennent une troisième résistance, interconnectant la grille et le drain dudit troisième transistor.

Selon un mode de mise en oeuvre préférentiel de l'invention, ledit troisième transistor est un transistor à substrat flottant.

Avantageusement, lesdits moyens de protection comprennent au moins une résistance connectée au drain respectivement dudit premier transistor et/ou dudit deuxième transistor.

Selon une caractéristique préférentielle de l'invention, au moins une desdites résistances est obtenue par au moins des techniques appartenant au groupe comprenant :
- un ajout d'une zone supplémentaire entre la grille et le drain ou la source du transistor de protection concerné ;
- un dopage par implantation d'ions azote et/ou phosphore ;
- suppression d'un siliciure sur ladite zone supplémentaire.

Avantageusement, ladite première portion dudit circuit comprend des moyens logiques et ladite seconde portion des moyens d'entrée/sortie.

L'invention concerne également des moyens de protection d'un circuit électronique comprenant une double alimentation, une première alimentation pour une première portion dudit circuit et une seconde alimentation pour une seconde portion dudit circuit, lesdits moyens de protection assurant la protection d'au moins un transistor de ladite première portion, comprenant un premier transistor de protection dont le drain est relié à une connexion entre ladite première portion et ladite seconde portion et la grille à ladite première alimentation,

Lesdits moyens de protection comprenant des premiers moyens de réduction de la tension entre le drain et la grille dudit premier transistor de protection.

### 5. Liste des figures

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :
- les figures 1 et 2 illustrent deux techniques de l'art antérieur, déjà commentées en préambule ;
- la figure 3 illustre les moyens de protection de l'invention ;
- la figure 4 est un exemple de courbe de variation du courant drain-source en fonction de la tension drain-source d'une part selon l'art antérieur et d'autre part selon l'invention.

### 6. Description d'un mode de réalisation de l'invention

Le principe général de l'invention repose sur l'utilisation de moyens de protection contre les dégradations anormales de deux transistors empilés d'un dispositif de protection d'un circuit intégré contre les dommages engendrés par les décharges électrostatiques. Selon l'invention, on réduit la tension drain-grille du premier transistor, par exemple à l'aide d'une résistance, pour éviter les problèmes de claquage.

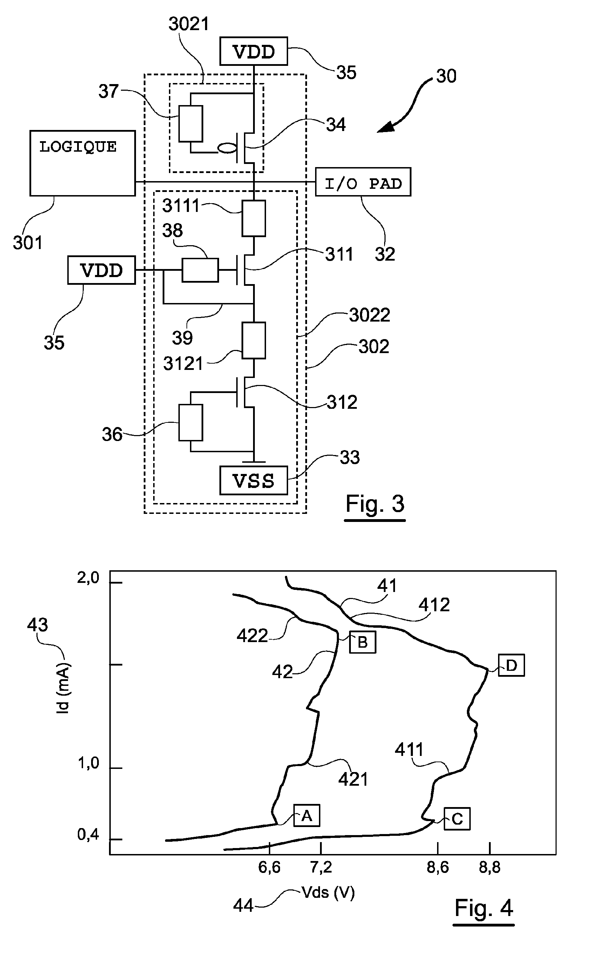

On présente, en relation avec la ***figure** 3,* un mode de réalisation préférentiel d'un dispositif de protection 302 selon l'invention contre les dommages engendrés par les décharges électrostatiques compris dans un circuit intégré 30.

Le circuit 30 comprend un module de logique 301, une alimentation 35 de 3V et un contact d'entrée/sortie 32 destiné à être relié à un autre circuit intégré alimenté par exemple au moyen d'une deuxième alimentation de 5V.

Le dispositif de protection 302 comprend une partie supérieure 3021 dédiée aux décharges électrostatiques positives. Cette partie supérieure 3021 comprend un transistor PMOS 34, dont la source est connectée au contact d'entrée/sortie 32, le drain est connecté à l'alimentation 35 et la grille est reliée, via une résistance 37, à l'alimentation 15. La valeur de la résistance 37 est par exemple de 1 kΩ.

Cette partie 3021 protège le circuit 30 des décharges électrostatiques positives en court-circuitant vers l'alimentation 35 le courant électrostatique de ces décharges.

Le dispositif de protection 302 comprend aussi une partie inférieure 3022 dédiée aux décharges électrostatiques négatives. Cette partie inférieure 3022 comprend deux transistors NMOS 311, 312 empilés. Ces transistors NMOS 311, 312 protègent le circuit 30 des décharges électrostatiques négatives en court-circuitant vers la masse le courant électrostatique de ces décharges.

Le drain du premier transistor 311 est connecté au contact d'entrée/sortie 32 ainsi qu'au transistor PMOS 34 et sa source est reliée au drain du second transistor NMOS 312. La grille du second transistor 312 NMOS est reliée via une résistance 36, dont la valeur est par exemple de 1 kΩ, à la masse 33 du circuit 30 et sa source, elle aussi, est reliée à la masse 33.

Comme expliqué précédemment en relation avec la figure 2, lorsque l'on applique sur le contact d'entrée/sortie 32 une tension supérieure à la tension d'alimentation 35 (de 3V), par exemple 5V, il en résulte qu'une tension importante est imposée aux transistors NMOS 311, 312 et PMOS 34. Des dégradations anormales des matériaux, tels que les couches d'oxyde ou les canaux de jonction, de ces transistors 311, 312 peuvent en résulter et rapidement entraîner le claquage de ces transistors 311, 312.

En conséquence, des moyens de protection contre ces dégradations anormales sont mis en oeuvre dans le dispositif de protection 302 selon l'invention. Selon l'invention, ces moyens sont compris dans la partie inférieure 3022.

Ces moyens comprennent une résistance de protection 38 connectée par une première extrémité à la grille du premier transistor NMOS 311 et par une seconde extrémité à l'alimentation 35. Cette résistance de protection 38 permet de réduire la tension appliquée entre le drain et la grille du transistor NMOS 311 et ainsi de réduire les dégradations anormales de ce transistor. La valeur de la résistance de protection 38 est par exemple de 500 Ω.

Ces moyens comprennent aussi une liaison 39 connectant la seconde extrémité de la résistance de protection 38 à la source du premier transistor 311. La liaison 39 permet de réduire, via la résistance de protection 38, la tension appliquée entre son drain et sa grille afin de réduire les dégradations anormales de ce transistor.

Afin d'éviter des dégradations anormales du transistor PMOS 34, il est avantageusement réalisé sur un substrat flottant qui permet de ne pas avoir de courant de fuite lorsque la jonction est polarisée en inverse.

L'empilement des deux transistors NMOS 311 et 312 permet d'obtenir une bonne protection contre les décharges électrostatiques. Ceci est illustré par la figure 4 qui présente une comparaison entre une première caractéristique 41 courant drain-source 43 noté Id en fonction de la tension drain-source 44 (notée Vds) du transistor 311 du circuit de la figure 3, et une seconde caractéristique 42 pour le transistor NMOS d'un dispositif de protection selon l'art antérieur ne comprenant qu'un seul transistor dans la partie inférieure dédiée aux décharges électrostatiques négatives.

Un premier avantage de l'invention est donc que l'empilement des deux transistors 311, 312 permet de retarder l'apparition du phénomène de porteurs chauds qui se caractérise sur chacune des caractéristiques 42, 41, respectivement par une bosse A, C. En effet, pour la seconde caractéristique 42 (un seul transistor), la bosse A correspond à Vds = 6,6V alors que pour la première caractéristique 41 (empilement de deux transistors), la bosse A correspond à Vds = 8,6V. On peut ainsi observer un retardement du phénomène de porteurs chauds de sensiblement 2V.

Un deuxième avantage est que, grâce à l'empilement, le phénomène dit de « snap back » (ou « départ en avalanche » en français) est lui aussi retardé. En effet, pour la seconde caractéristique 42, le point B où la pente change de signe, ce qui caractérise l'apparition de ce phénomène, correspond à Vds = 7,2V alors que pour la première caractéristique 41, le point D correspond à Vds = 8,8V. On peut ainsi observer un retardement du phénomène de « snap back » de sensiblement 1,6V.

Selon un mode de mise en oeuvre préférentiel de l'invention, on ajoute une résistance 3111, 3121 sur le drain de chacun des transistors NMOS 311, 312 du circuit 30 de la figure 3. Ces résistances 3111, 3121, dont la valeur est par exemple 7 Ω, permettent d'obtenir le changement du signe de la pente de la caractéristique 42 Id en fonction de Vds (cf. figure 4) caractérisant l'entrée dans la zone de « snap back ».

Ces résistances 3111, 3121 sont réalisées lors de la conception des transistors NMOS 311, 312 au moyen des étapes suivantes :
- ajout d'une zone supplémentaire entre leur grille et leur drain par un relâchement de la distance poly contact ;
- dopage de cette zone par implantation d'ions arsenic et/ou phospore ;
- suppression du siliciure sur cette zone supplémentaire.

Bien entendu, l'invention n'est pas limitée aux exemples de réalisation mentionnés ci-dessus.

En particulier, l'Homme du Métier pourra apporter toute variante dans les moyens de protection contre les dégradations anormales des transistors du dispositif de protection du circuit intégré contre les décharges électrostatiques.

Il pourra notamment mettre en oeuvre des moyens de protection comprenant d'autres composants électroniques, en quantité et aux emplacements adaptés aux caractéristiques des circuits intégrés, de leur dispositif de protection et de la tension fournie en sortie du circuit.

De même selon des variantes de ces exemples de réalisation, les moyens de protection peuvent être mis en oeuvre à d'autres emplacements du circuit intégré.

## Revendications

1. Circuit électronique comprenant une double alimentation, une première alimentation pour une première portion dudit circuit et une seconde alimentation pour une seconde portion dudit circuit,
et des moyens de protection d'au moins un transistor de ladite première portion, comprenant un premier transistor de protection (311) dont le drain est relié à une connexion entre ladite première portion et ladite seconde portion et la grille à ladite première alimentation,
**caractérisé en ce que** ledit premier transistor de protection (311) est monté en diode et **en ce que** le circuit électronique comprend des premiers moyens de réduction de la tension entre le drain et la grille dudit premier transistor de protection (311).

2. Circuit électronique selon la revendication 1, **caractérisé en ce que** lesdits premiers moyens de réduction de la tension comprennent une première résistance (38) montée entre la grille et la source dudit premier transistor (311).

3. Circuit électronique selon la revendication 2, **caractérisé en ce que** ladite première résistance (38) est montée entre ladite première alimentation et la grille dudit premier transistor de protection, la source de ce dernier étant directement reliée à ladite première alimentation.

4. Circuit électronique selon l'une quelconque des revendications 1 à 3,
**caractérisé en ce que** lesdits moyens de protection comprennent un deuxième transistor (312), dont le drain est relié à la source dudit premier (311) transistor et la source est reliée à la masse.

5. Circuit électronique selon la revendication 4, **caractérisé en ce que** lesdits moyens de protection comprennent une deuxième résistance (36), interconnectant la grille et la source dudit deuxième transistor (312).

6. Circuit électronique selon l'une quelconque des revendications 4 et 5,
**caractérisé en ce que** lesdits premier et deuxième transistors (311, 312) sont identiques.

7. Circuit électronique selon l'une quelconque des revendications 1 à 6,
**caractérisé en ce que** lesdits moyens de protection comprennent un troisième transistor (34) dont la source est reliée à ladite connexion entre ladite première portion (301) et ladite seconde portion (32) et le drain à ladite première alimentation (35).

8. Circuit électronique selon la revendication 7, **caractérisé en ce que** lesdits moyens de protection comprennent une troisième résistance (37), interconnectant la grille et le drain dudit troisième transistor (34).

9. Circuit électronique selon l'une quelconque des revendications 7 et 8,
**caractérisé en ce que** ledit troisième transistor (34) est un transistor à substrat flottant.

10. Circuit électronique selon l'une quelconque des revendications 1 à 9,
**caractérisé en ce que** lesdits moyens de protection comprennent au moins une résistance (3111, 3121) connectée au drain respectivement dudit premier transistor et/ou dudit deuxième transistor.

11. Circuit électronique selon l'une quelconque des revendications 2 à 10,
**caractérisé en ce qu'**au moins une desdites résistances (3111, 3121) est obtenue par au moins des techniques appartenant au groupe comprenant :
- un ajout d'une zone supplémentaire entre la grille et le drain ou la source du transistor de protection concerné ;
- un dopage par implantation d'ions arsenic et/ou phosphore ;
- suppression d'un siliciure sur ladite zone supplémentaire.

12. Circuit électronique selon l'une quelconque des revendications 1 à 11,
**caractérisé en ce que** ladite première portion dudit circuit comprend des moyens logiques (301) et ladite seconde portion des moyens d'entrée/sortie (32).

13. Moyens de protection d'un circuit électronique (30) comprenant une double alimentation, une première alimentation (35) pour une première portion dudit circuit et une seconde alimentation pour une seconde portion dudit circuit (32),
lesdits moyens de protection assurant la protection d'au moins un transistor de ladite première portion, comprenant un premier transistor de protection (311) dont le drain est relié à une connexion entre ladite première portion (301) et ladite seconde portion (32) et la grille à ladite première alimentation (35),
**caractérisés en ce que** ledit premier transistor de protection (311) est monté en diode et **en ce que** les moyens de protection comprennent des premiers moyens de réduction (38) de la tension entre le drain et la grille dudit premier transistor de protection (311).
